Europäisches Patentamt

(19) European Patent Office

Office européen des brevets

(11) Publication number: **0 090 543**
**B1**

# (12) EUROPEAN PATENT SPECIFICATION

(45) Date of publication of the patent specification: 05.02.86

(51) Int. Cl.⁴: **H 03 F 1/32, H 03 F 3/45**

(21) Application number: **83301420.2**

(22) Date of filing: **15.03.83**

(54) Differential amplifier with improved linear amplification.

(30) Priority: **30.03.82 JP 50094/82**

(43) Date of publication of application:
**05.10.83 Bulletin 83/40**

(45) Publication of the grant of the patent:
**05.02.86 Bulletin 86/6**

(84) Designated Contracting States:
**DE FR GB**

(56) References cited:
**DE - A - 2 846 940**
**DE - A - 3 035 471**
**DE - A - 3 138 078**
**DE - B - 2 204 419**

(73) Proprietor: **FUJITSU LIMITED, 1015, Kamikodanaka Nakahara-ku, Kawasaki-shi Kanagawa 211 (JP)**

(72) Inventor: **Sano, Yoshiaki, Azamino-danchi 6-103 3, Azamino 4-chome, Midori-ku Yokohama-shi Kanagawa 227 (JP)**

(74) Representative: **Skone James, Robert Edmund et al, GILL JENNINGS & EVERY 53-64 Chancery Lane, London WC2A 1HN (GB)**

## Description

The present invention relates to a differential amplifer particularly for audio-frequency linear amplification.

A differential amplifier may be used for amplifying an alternating current or voltage having an audio frequency. Therefore, the linear amplification characteristics are important.

A Prior art differential amplifier comprises first and second transistors connected, via negative feedback resistors , to a common current source. In this prior art, since the emitter-base diodes of the transistors which have logarithmic characteristics are made use of, the amplification characteristics are nonlinear, which is a disadvantage.

According to the present invention a differential amplifier comprises a primary current source for producing a first current; first and second transistors having a first Polarity, each of the transistors having a collector serving as an output terminal, base, and an emitter connected, via an emitter resistance to the primary current source; and is characterized by first and second current sources for producing a second current, the bases of the first and second transistors being connected to the first and second current sources respectively; a third transistor having the first polarity, the third transistor having a collector connected to the first current source, a base connected to the emitter of the first transistor , and an emitter for receiving a first input signal; and a fourth transistor having the first polarity, the fourth transistor having a collector connected to the second current source, a base connected to the emitter of the second transistor, and an emitter for receiving a second input signal.

This invention provides a differential amplifier in which the linear amplification characteristics are improved. Essentially, a current source and a transistor connected in series are provided on each side of the first and second transistors, and, accordingly, the potential at the base of the first and second transistors is negatively fed back to the emitter thereof. As a result, the base emitter voltage of the first and second transistors is almost constant, with the result that the linear amplification characteristics are improved.

Two examples of differential amplifiers in accordance with the present invention will now be described and contrasted with the prior art with reference to the accompanying drawings, in which:

Figure 1 is a circuit diagram illustrating aprior art differential amplifier;

Figure 2 is a graph showing the amplification characteristics of the differential amplifier of Fig. 1;

Fig. 3 is a circuit diagram illustrating a first embodiment of the differential amplifier according to the present invention;

Fig. 4 is a circuit diagram illustrating the current source $IP_1$ of Fig. 3;

Fig. 5 is a circuit diagram illustrating the current sources $Ip_2$ and $IP_3$ of Fig. 3;

Fig. 6 is a graph showing the amplification characteristics of the differential amplifier of Fig. 3;

Fig. 7 is a circuit diagram illustrating a second embodiment of the differential amplifier according to the present invention; and

Fig. 8 is a circuit diagram of the current sources $IP_1'$ and $IP_1'$ of Fig.7.

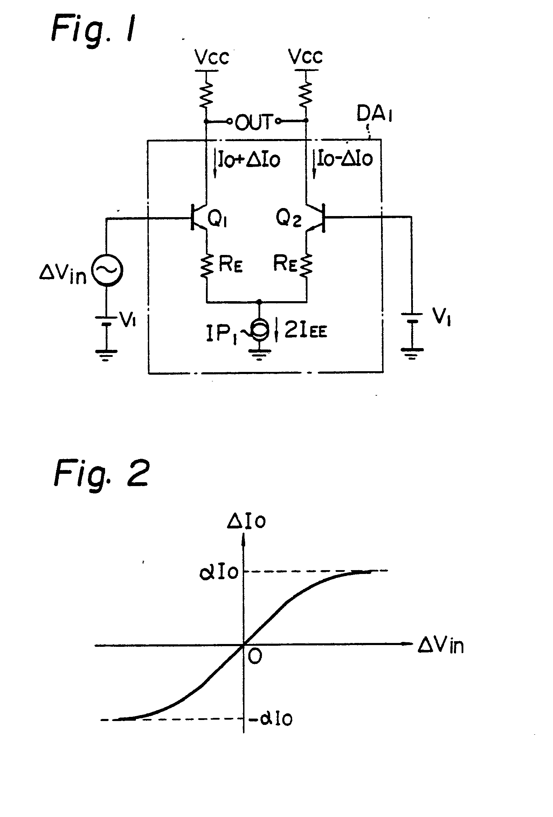

In Fig. 1, which illustrates a prior art differential amplifier, a pair of transistors $Q_1$ and $Q_2$ are connected via negative feedback resistors $R_E$ to a common current source $IP_1$. A differential input voltage $\Delta V_{in}$ is applied to the base of the transistor $Q_1$, and an output $\Delta I_0$ is obtained by avoltage/current conversion gain based on a bias condition $(2I_{EE})$. Note that, in this case, the of set voltage between the transistors $Q_1$ and $Q_2$ becomes zero when $\Delta V_{in}$ equals zero. The potential $V_1 + \Delta V_{in}$ is represented by:

$$V_1 + \Delta V_{in} = V_{BE1} + \frac{1 + h_{FE}}{h_{FE}} (I_0 + \Delta I_0) \cdot R_E + V_{IP1} \qquad \cdots \cdots (1)$$

where $V_{BE1}$ is the base-emitter voltage of the transistor $Q_1$,

$h_{FE}$ is the current am lification factor and $V_{IP1}$ is the voltage drop of the current source $IP_1$. The potential $V_1$ is represented by:

$$V_1 = B_{BE2} + \frac{1 + h_{FE}}{h_{FE}} (I_0 - \Delta I_0) \cdot R_E + V_{IP1} \qquad \cdots \cdots (2)$$

where $V_{BE2}$ is the base-emitter voltage of the transistor $Q_2$. Therefore, f rom the equations (1) and (2),

$$\Delta V_{in} = V_{BE1} - V_{BE2} + 2 \cdot \frac{1 + h_{FE}}{h_{FE}} \Delta I_0 \cdot R_E \qquad \cdots \cdots (3)$$

The transistors $Q_1$ and $Q_2$ operate based upon the following logarithmic voltage/current characteristics:

$$V_{BE} = \frac{kT}{q} \ell n \frac{I_c}{I_s}$$

where $V_{BE}$ is the transistor's emitter-base voltage, $I_c$ is the transistor's collector current, $I_s$ is the collector saturation current, k is Boltzmann's constant, q is the charge of one electron, and T is the absolute temperature in kelvins. Therefore, the equation (3) is replaced by:

2

$$\Delta V_{in} = \frac{kT}{q} \ln \frac{I_0 + \Delta I_0}{I_s} - \frac{kT}{q} \ln \frac{I_0 - \Delta I_0}{I_s}$$

$$+ 2 \cdot \frac{1 + h_{FE}}{h_{FE}} \Delta I_0 \cdot R_E$$

$$= \frac{kT}{q} \ln \frac{I_0 + \Delta I_0}{I_0 - \Delta I_0} + 2 \cdot \frac{1 + h_{FE}}{h_{FE}} \Delta I_0 \cdot R_E \qquad \ldots \ (4)$$

Thus, if $\Delta I_0/I_0] 1$ (in the case of a signal having a small amplitude),

$$\Delta V_{in} \simeq 2 \cdot \frac{1 + h_{FE}}{h_{FE}} \Delta I_0 \cdot R_E \qquad \ldots \ (5)$$

Therefore, the linear amplification characteristics are obtained. Nowever, as $\Delta I_0$ increases, the first expression of the equivalent in the equation (4) causes a large error, thereby deteriorating the linear amPlification characteristics, as is shown in Fig. 2. In Fig. 2, note that equals $h_{FE}/ (1 + h_{FE})$ and is apProximately 1.

In the equation (4), in order to improve the linear amplification characteristics, one approach is to increase I ($= \alpha I_{EE}$) in the first expression of the equivalent. In this approach, however, $I_{EE}R_E$ is increased, with the result that the efficiency of the power supply is reduced. Another approach is to increase $R_E$ in the second expression of the equivalent. In this approach, however, the efficiency of the power supply is also reduced, and, in addition, the gain $\Delta I_0/\Delta V_{in}$ is reduced.

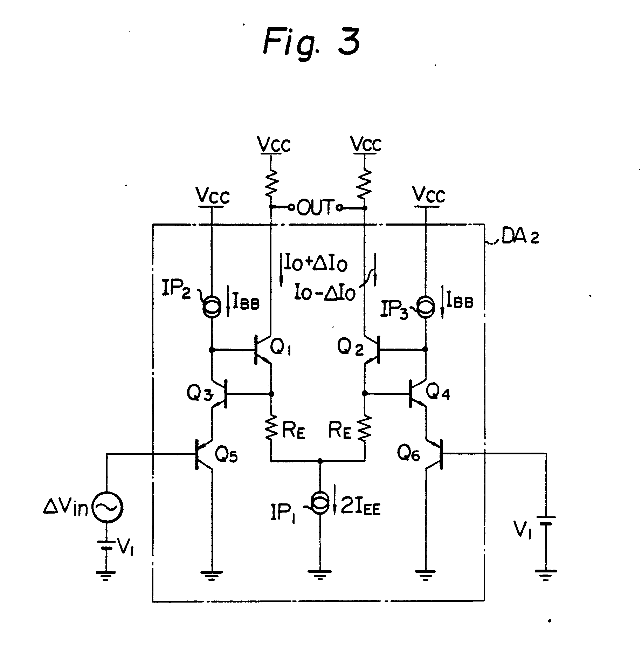

In Fig. 3, which illustrates a first embodiment of the present invention, transistors $Q_3$ and $Q_4$ having the same polarity as the transistors $Q_1$ and $Q_2$ , transistors $Q_5$ and $Q_6$ having a polarity opposite to that of the transistors $Q_1$ and $Q_2$, and two current sources $IP_2$ and $IP_3$ are added to the differential amplifier $DA_1$ of Fig. 1.

The base current and emitter current of the transistor $Q_1$ are

$$\frac{1}{h_{FE}} (I_0 + \Delta I_0) \quad and \quad \frac{1 + h_{FE}}{h_{FE}} (I_0 + \Delta I_0) ,$$

respectively, and, accordingly, the collector current of the transistor $Q_3$ is

$$I_{BB} - \frac{1}{h_{FE}} (I_0 + \Delta I_0) .$$

In addition, the base current and emitter current of the transistor $Q_3$ are

$$\frac{1}{h_{FE}} I_{BB} - \frac{1}{h_{FE}^2} (I_0 + \Delta I_0) \quad and$$

$$\frac{1 + h_{FE}}{h_{FE}} \left\{ I_{BB} - \frac{1}{h_{FE}} (I_0 + \Delta I_0) \right\} ,$$

respectively, and, accordingly, the current flowing through the resistor $R_E$ on the left side is

$$(\frac{1 + h_{FE}}{h_{FE}} + \frac{1}{h_{FE}^2}) (I_0 + \Delta I_0) - \frac{1}{h_{FE}} I_{BB} .$$

Further, the collector current of the transistor $Q_6$ is the same as that of the transistor $Q_3.$ Similarly, the base current and emitter current of the transistor $Q_2$ are

$$\frac{1}{h_{FE}} (I_0 - \Delta I_0) \quad and \quad \frac{1 + h_{FE}}{h_{FE}} (I_0 - \Delta I_0) ,$$

respectively, and, accordingly, the collector current of the transistor $Q_4$ is

$$I_{BB} - \frac{1}{h_{FE}} (I_0 - \Delta I_0) .$$

In addition, the base current and emitter current of the transistor $Q_4$ are

$$\frac{1}{h_{FE}} I_{BB} - \frac{1}{h_{FE}^2} (I_0 - \Delta I_0) \quad \text{and}$$

$$\frac{1 + h_{FE}}{h_{FE}} \left\{ I_{BB} - \frac{1}{h_{FE}} (I_0 - \Delta I_0) \right\},$$

respectively, and, accordingly, the current flowing through the resistor $R_E$ on the right side is

$$\left( \frac{1 + h_{FE}}{h_{FE}} - \frac{1}{h_{FE}^2} \right)(I_0 - \Delta I_0) - \frac{1}{h_{FE}^2} I_{BB}.$$

Further, the collector current of the transistor $Q_6$ is the same as that of the transistor $Q_4$.
Therefore, the potential $V_1 + \Delta V_{in}$ is represented by

$$V_1 + V_{in} = \left\{ \left( \frac{1 + h_{FE}}{h_{FE}} - \frac{1}{h_{FE}^2} \right)(I_0 + \Delta I_0) - \frac{1}{h_{FE}^2} I_{BB} \right\} R_E$$

$$+ V_{IP1} - V_{BE3} - V_{BE5} \qquad \qquad \cdots \cdot (6)$$

where $V_{BE3}$ and $V_{BE5}$ are the base emitter voltages of the transistors $Q_3$ and $Q_5$, respectively. On the other hand, the potential $V_1$ is represented by

$$V_1 = \left\{ \left( \frac{1 + h_{FE}}{h_{FE}} - \frac{1}{h_{FE}^2} \right)(I_0 - \Delta I_0) - \frac{1}{h_{FE}^2} I_{BB} \right\} R_E$$

$$+ V_{IP1} - V_{BE4} - V_{BE6} \qquad \qquad \cdots \cdot (7)$$

where $V_{BE4}$ and $V_{BE6}$ are the base emitter voltages of the transistors $Q_4$ and $Q_5$, respectively. Thus, from the equations (6) and (7),

$$\Delta V_{in} = V_{BE4} + V_{BE6} - V_{BE3} - V_{BE5}$$

$$+ 2 \left( \frac{1 + h_{FE}}{h_{FE}} - \frac{1}{h_{FE}^2} \right) \Delta I_0 \cdot R_E$$

$$= \frac{2kT}{q} \ell n \frac{I_{BB} - \frac{1}{h_{FE}} (I_0 - \Delta I_0)}{I_{BB} - \frac{1}{h_{FE}} (I_0 + \Delta I_0)}$$

$$+ 2 \left( \frac{1 + h_{FE}}{h_{FE}} - \frac{1}{h_{FE}^2} \right) \Delta I_0 \cdot R_E$$

Generally, since $h_{FE} \gg 1$,

$$\Delta V_{in} = \frac{2kT}{q} \ell n \frac{(h_{FE} I_{BB} - I_0) + \Delta I_0}{(h_{FE} I_{BB} - I_0) - \Delta I_0}$$

$$+ \left( 2 \frac{1 + h_{FE}}{h_{FE}} \right) \Delta I_0 \cdot R_E \qquad \qquad \cdots \cdot (8)$$

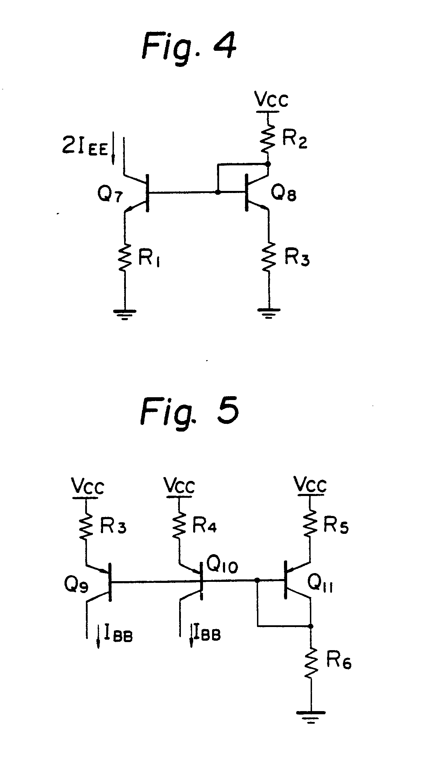

Therefore, if $(h_{FE} I_{BB} - I_0) \gg \Delta I_0$, the first expression of the equivalent in the equation (8) is nearly zero, and, accordingly, the first expression hardly affects the second expression of the equivalent at all.
The current source $IP_1$ is constructed with a current mirror circuit, as is shown in Fig. 4, in which two transistors $Q_7$ and $Q_8$ are provided. The current $2I_{EE}$ is set by resistors $R_1$, $R_2$, and $R_3$. The current sources $IP_2$

4

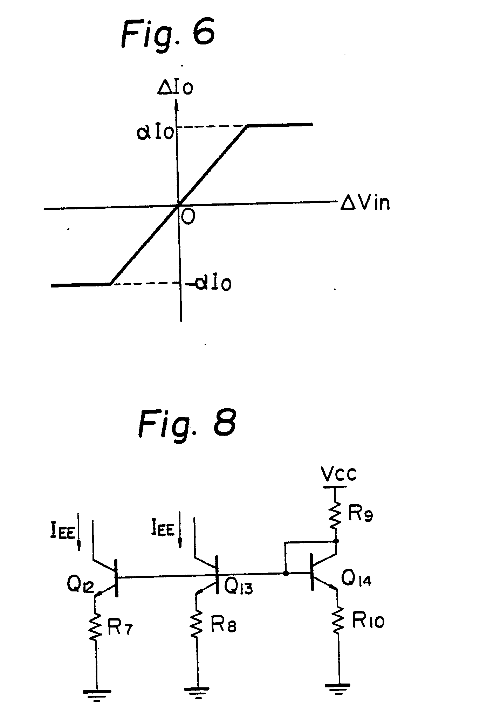

and $IP_3$ are also constructed with a current mirror circuit, as is shown in Fig. 5, in which three transistors $Q_9$, $Q_{10}$, and $Q_{11}$ are provided. The current $I_B$ is set by resistors $R_3$, $R_4$, $R_5$, and $R_6$. In this case, $R_3 = R_4$. Therefore, since the currents $I_{BB}$ and $I_{EE}$ ($\cong I_0$) can be arbitrarily set, the above-mentioned condition ($h_{FE}I_{BB} - I_0) \gg \Delta I_0$ is possible. As can be seen from the amplification characteristics, represented by the equation (8), shown in Fig. 6, the linearity of the ratio $\Delta I_0$ to $\Delta V_{in}$ is improved.

That is, in Fig. 3, the current $I_{BB}$ flows mainly through the transistors $Q_3$ and $Q_5$ (or the transistors $Q_4$ and $Q_6$). As a result, the transistors $Q_3$ and $Q_5$ serve only as a battery. Therefore, the emitter voltage of the transistor $Q_1$ changes immediately after $\Delta V_{in}$ changes. In addition, the collector voltage of the transistor $Q_3$ changes immediately after the base voltage thereof changes. In other words, the base voltage of the transistor $Q_1$ is negatively fed back to the emitter voltage thereof.

It should be noted that the transistors $Q_5$ and $Q_6$, are not indispensable. If the circuits for $\Delta V_{in}$ and $V_1$ have a low impedance, they can be omitted.

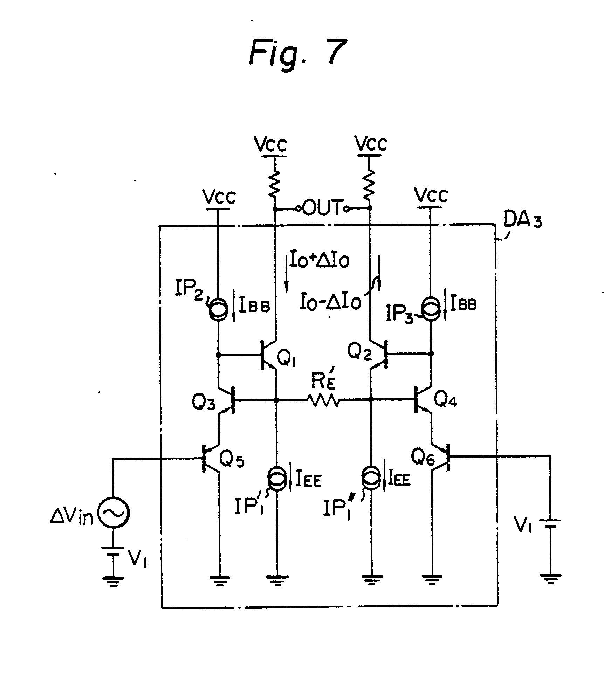

In Fig. 7, which illustrates a second embodiment of the present invention, two current sources $IP_1'$ and $IP_1'$ and an emitter resistor $R_E'$ are provided instead of the current source $IP_1$ and the emitter resistors $R_E$ of Fig. 3. The current sources $IP_1'$ and $IP_1'$ are also constructed with a current mirror circuit, as is shown in Fig. 8, in which three transistors $Q_{12}$, $Q_{13}$, and $Q_{14}$ are provided. The current $I_{EE}$ is set by resistors $R_7$, $R_8$, $R_9$, and $R_{10}$. In this case, $R_7 = R_8$. The operation of the differential amplifier $DA_3$ of Fig. 7 is exactly the same as that of the differential amplifier $DA_2$ of Fig. 3.

In Figs. 3 and 7, the transistors $Q_1$ and $Q_2$ can be constructed with a Darlington circuit so as to increase the current gain. In addition, the polarities of all the transistors can be reversed.

In Fig. 3, when $2I_{EE} = 0.2$ mA, $I_{BB} = 0.1$ mA, and $R_E = 260\Omega$ and when the amplitude of $\Delta V_{in}$ is only a quarter of the full amplitude, the distortion is less than

0. 01%. On the other hand, in the prior art differential amplifier $DA_1$, the distortion is about 1.1 % under the same conditions.

**Claims**

1. A differential amplifier ccmprising a primary current source ( $IP_1$) for producing a first current ($2I_{EE}$); first and second transistors ($Q_1$, $Q_2$) having a first polarity, each of the transistors having a collector serving as an output terminal, a base, and an emitter connected, via an emitter resistance ($R_E$), to the prima ry current source; characterized by first and second current sources ($IP_2$, $IP_3$) for producing a second current ($I_{BB}$), the bases of the first and second transistors ($Q_1$, $Q_2$) being connected to the first and second current sources respectively; a third transistor ($Q_3$) having a collector connected to the first current source ($IP_2$), a base connected to the emitter of the first transistor ($Q_1$), and an emitter for receiving a first input signal ($\Delta V_{in}$); and a fourth transistor ($Q_4$) having the first polarity, the fourth transistor having a collector connected to the second current source ($IP_3$), a base connected to the emitter of the second transistor ($Q_2$), and an emitter for receiving a second input signal ($V_1$).

2. A differential amplifier according to claim 1, wherein the primary current source ($IP_1$) comprises third and fourth current sources ($IP_1'$, $IP_1'$) for produ cing the first current ($I_{EE}$), the emitters of the first and second transistors ($Q_1$, $Q_2$) being connected to the third and fourth current sources, respectively; and wherein the emitters of the first and second transistors ($Q_1$, $Q_2$) are connected to a common emitter resistance ($R_E'$).

3. A differential amplifier according to claim 1 or claim 2, further comprising a fifth transistor ($Q_5$) having a second polarity opposite to the first polarity, the fifth transistor having an emitter connected to the emitter of the third transistor ($Q_3$), a base for receiving the first input signal ($\Delta V_{in}$), and a collector; and a sixth transistor ($Q_6$) having the second polarity, the sixth transistor having an emitter connected to the emitter of the fourth transistor ($Q_4$), a base for receiving the second input signal($V_{in}$), and a collector.

**Revendications**

1. Amplificateur différentiel comprenant une source de courant principa le (IPI) servant à produire un premier courant ($2I_{EE}$); un premier et un deuxième transistor ($Q_1$, $Q_2$) ayant une première polarité qui possèdent chacun un collecteur servant de borne de sortie, une base, et un émetteur connecté, via une rési stance d'émetteur ($R_E$), à la source de courant principale ; caractérisé par une première et une deuxième source de courant ($IP_2$, $IP_3$) servant à produire un deuxième courant ($I_{BB}$), les bases des premier et deuxième transistors ($Q_1$, $Q_1$) étant respectivement connectées aux première et deuxième sources de courant; un troisième transistor ($Q_3$) dont le collecteur est connecté à la première source de courant ($IP_2$), la base est connectée à l'émetteur du premier transistor ($Q_1$), et l'émetteur est destiné à recevoi r un premier signal d'entrée ($\Delta V_{in}$) ; et un quatrième transistor($Q_4$)présentant la première polarité, dont le collecteur est connecté à la deuxième source de courant ($IP_3$), la base est connectée à l'émetteur du deuxième transistor ($Q_2$), et l'emetteur est destiné à recevoir un deuxième signal d'entrée ($V_1$).

2. Amplif icateur différentiel selon la revendication 1, où la source de courant principale ($IP_1$) comprend une troisième et une quatrième source de courant ($IP_1'$, $IP_1'$) servant à produire le premier courant ($I_{EE}$), les émetteurs des premier et deuxième transistors($Q_1$, $Q_2$) étant respectivement connectés aux troisième et quatrième sources de courant; et où les émetteurs des premier et deuxième transistors ($Q_1$, $Q_2$) sont connectés à une résistance d'émetteur commune ($R'_E$).

3. Amplificateur différentiel selon la revendication 1 ou 2, comprenant en outre un cinquième transi stor ($Q_5$) présentant une deuxième polarité, opposée à la première polarité, le cinquième transistor comportant un émetteur connecté à l'émetteur du troisième transistor ($Q_3$), une base destinée à recevoir le premier signal d'entrée ($\Delta V_{in}$), et un collecteur; et un sixième transistor ($Q_6$) presentant la deuxième polarité, le sixième transistor comportant un émetteur connecté à l'émetteur du quatrième transistor ($Q_4$), une base destinée à recevoir le deuxième signal d'entrée ($V_{in}$), et un collecteur.

**Patentansprüche:**

1. Differenzverstärker mit einer primären Stromquelle (IPI) zur Erzeugung eines ersten Stroms ($2I_{EE}$); ersten und zweiten Transistoren ($Q_1$, $Q_2$) von einer ersten Polarität, von denen jeder Transistor einen Kollektor hat, der als Ausgangsanschluß dient, eine Basis und einen Emitter, der, über einen Emitterwiderstand ($R_E$) mit der primären Stromquelle verbunden ist; gekennzeichnet durch erste und zweite Stromquellen ($IP_2$, $IP_3$) zur Erzeugung eines zweiten Stroms ($I_{BB}$), wobei die Basen der ersten und zweiten Transistoren ($Q_1$ $Q_2$) mit der ersten bzw. der zweiten Stromquelle verbunden sind; einen dritten Transistor ($Q_3$) mit einem Kollektor, der mit der ersten Stromquelle ($IP_2$) verbunden ist, einer Basis, die mit dem Emitter des ersten Transistors ($Q_1$) verbunden ist, und einem Emitter zum Empfang eines ersten Eingangssignals ($\Delta V_{in}$); und einen vierten Transistor ($Q_4$), der eine erste Polarität hat, und einen Kollektor hat, der mit der zweiten Stromquelle ($IP_3$) verbunden ist, eine Basis, die mit dem Emitter des zweiten Transistors ($Q_2$) verbunden ist, und einen Emitter zum Empfang eines zweiten Eingangssignals ($V_1$).

2. Differenzverstärker nach Anspruch 1, bei welchem die primäre Stromquelle ($IP_1$) dritte und vierte Stromquellen ($IP_1'$, $IP_1'$) zur Erzeugung des ersten Stroms ($I_{EE}$) umfaßt, die Emitter der ersten und zweiten Transistoren ($Q_1$, $Q_2$) mit den dritten bzw. vierten Stromquellen verbunden sind; und bei welchem die Emitter der ersten und zweiten Transistoren ($Q_1$ $Q_2$) mit einem gemeinsamen Emitterwiderstand ($R_E'$) verbunden sind.

3. Differenzverstärker nach Anspruch 1 oder 2, ferner mit einem fünften Transistor ($Q_6$) der eine zweite, zur ersten Polarität entgegengesetzte Polarität aufweist und der einen Emitter hat, der mit dem Emitter des dritten Transistors ($Q_3$) verbunden ist, eine Basis zum Empfang des ersten Eingangssignals ($\Delta V_{in}$) und einen Kollektor; und mit einem sechsten Transistor ($Q_8$), der eine zweite Polarität und einen Emitter hat, der mit dem Emitter des vierten Transistors ($Q_4$) verbunden ist, eine Basis zum Empfang des zweiten Eingangssignals ($V_{in}$), und einen Kollektor.

# Fig. 1

# Fig. 2

# Fig. 3

# Fig. 4

# Fig. 5

# Fig. 6

# Fig. 8

# Fig. 7